# EUROPÄISCHE PATENTSCHRIFT

(11) **EP 2 193 700 B1**
(45) Veröffentlichungstag und Bekanntmachung des Hinweises auf die Patenterteilung: **27.07.2016**
(21) Anmeldenummer: 08803088.7
(22) Anmeldetag: 19.08.2008
(51) Int. Cl.: F04D 29/70, H05K 5/02, H05K 7/20

(54) **SCHALTSCHRANK FÜR EINE WINDKRAFTANLAGE**
SWITCHGEAR CABINET FOR A WIND FARM
ARMOIRE DE COMMUTATION POUR ÉOLIENNE

(30) Priorität: 12.09.2007 DE 102007043503
(43) Veröffentlichungstag der Anmeldung: 09.06.2010
(73) Patentinhaber: SSB Wind Systems GmbH & Co. KG, 48499 Salzbergen (DE)
(72) Erfinder: KESTERMANN, Hermann, 48432 Rheine (DE); ZWARTJES, Cathrin, 38118 Braunschweig (DE)
(86) Internationale Anmeldenummer: PCT/EP2008/060843
(87) Internationale Veröffentlichungsnummer: WO 2009/033917

(56) Entgegenhaltungen:
- DE-U1-202006 006 326
- JP-A- 8 061 724
- JP-A- 10 132 345
- JP-A- H08 159 084
- JP-A- H10 270 878
- JP-A- 2006 074 956

## Beschreibung

Die Erfindung betrifft einen Schaltschrank für eine Windkraftanlage, der im Betrieb einer Rotation ausgesetzt ist, mit einem Schrankgehäuse, in dem wenigstens ein Lüftungsloch in einer Wand des Schrankgehäuses vorgesehen ist, und wenigstens einem in dem Schrankgehäuse angeordneten Lüfter, der vor und/oder in dem Lüftungsloch sitzend an dem Schrankgehäuse befestigt ist. Ferner betrifft die Erfindung eine Windkraftanlage mit einem solchen Schaltschrank.

Aus der GB 1 199 831 A ist eine Dachventilationseinheit bekannt, wobei zwei Klappen im geschlossenen Zustand eine Abdeckung für einen Ventilator bilden. Die Klappen sind außerhalb eines Rohrs angelenkt, in dem der Ventilator sitzt, um im geöffneten Zustand die Bildung von Turbulenzen im Luftstrom zu reduzieren.

Im geschlossenen Zustand der Klappen verschließen diese die Luftdurchtritsöffhung, und im geöffneten Zustand der Klappen ist der Ventilator nicht vor dem Einbringen von Wasser geschützt. Ferner sind die Klappen und der Ventilator an einem Dach befestigt und nicht für die Montage an einem Schaltschrank vorgesehen.

Die DE 92 12 876 U1 beschreibt einen Lüfter für einen Anschluss an einen Wassertröpfchen enthaltenden Raum, mit einem Lüftergehäuse mit einem axialen Lufteintritt und einem umfangsseitigen Austritt, einem im Lüftergehäuse angeordneten Lüfterrad mit einer Welle und einer Wellendurchführung an der dem Lufteintritt gegenüberliegenden Seite. Das Gehäuse hat einen die Wellendurchführung an der Gehäuseseite umgebenden Wandvorsprung, der z.B. konisch ausgebildet ist.

Es werden keine Maßnahmen ergriffen, um ein Eindringen von Flüssigkeit in das Lüftergehäuse zu verhindern, vielmehr wird dieses Eindringen in Kauf genommen.

Die DE 196 36 500 C2 offenbart einen Dichteinsatz für ein elektrisches Installationsgerät, der einen hohlzylindrischen Mantel und einen hieran rechtwinklig angeformten Kragen aufweist. An seinem äußeren Rand ist der Kragen mit einem Süllrand versehen, an dessen Ende ein umlaufender und nach außen weisender Vorsprung angeformt ist, welcher in den Randbereich eines Abdeckrahmens eingreift, um hierdurch das Eindringen von Feuchtigkeit oder Wasser zu verhindern.

Mit dieser Anordnung kann lediglich ein seitliches aber nicht ein frontales Eindringen von Wasser verhindert werden, da die Abdeckung als Rahmen ausgebildet ist. Ferner ist das Installationsgerät für den Unterputzeinbau und nicht für die Montage in einem Schaltschrank vorgesehen.

Die DE 20 2006 006 326 U1 offenbart einen Schaltchrank zur Aufnahme von elektrischen und elektronischen Bau- und Schaltelementen, der einer Rotation ausgesetzt ist und der mindestens ein Kühlgerät mit einem in seinem Innenraum liegenden Kälte abgebenden Geräteteil und einem außerhalb des Schaltschrankes liegenden Wärme abgebenden Geräteteil aufweist, wobei im Bereich der im Innenraum des Schaltschrankes liegenden kalten Seite des in einer Wand des Schaltschrankes angeordneten Kühlgerätes ein Kondensatring als schalenförmige Auffangwanne für anfallendes Kondenswasser angeordnet ist, deren Innenraum mit einem aus dem Innenraum des Schallschrankes herausgeführten Schlauch verbunden ist, der im Bereich der außerhalb des Schaltschrankes liegenden warmen Seite des Kühlgerätes spiralförmig ausgebildet ist, wobei der spiralförmig ausgebildete Abschnitt des Schlauches als Spirale mit konstantem Radius oder als sich öffnende Spirale ausgebildet ist, und wobei Parallelität der Achsen von einer Rotorwelle einer Windkraftanlage und dem den Kühlkörper umschließenden Kondensatring besteht.

Die JP H10 270878 A offenbart einen zylindrischen Lüfterrahmen mit stirnseitig aufgeweiteten Enden, in dem ein Lüfter sitzt. Der Lüfterrahmen ist fest mit einer Montageplatte verbunden, die an einer Wand eines Schaltschranks befestigt ist. Die Wand umfasst eine durchgehende Montageöffnung für den Lüfter, in welche der Lüfterrahmen eingesetzt ist. Das Ende des Lüfterrahmens greift in eine Abdeckung ein.

Die JP H08 159084 A offenbart eine in einem Dach vorgesehene Lüftungsöffnung, die gegenüber dem Montageort eines Ventilators vorgesehen ist. Ein Flansch steht vom Rand der Lüftungsöffnung vor und ist von einer Abdeckung mit Lüftungslöchern abgedeckt.

Schaltschränkc der eingangs genannten Art sind aus dem Stand der Technik bekannt und werden in Windkraftanlagen z.B. für die Aufnahme von elektronischen Komponenten zur Steuerung von Pitch-Antrieben eingesetzt, sodass diese Schaltschränke auch als Pitch-Schaltschränke bezeichnet werden. In Windkraftanlagen ist die Klimatisierung von Pitch-Schaltschränkcn problematisch, wenn bei (zeitweise) hohen Umgebungstemperaturen in der Nabe gleichzeitig hohe Leistungen und somit auch hohe Verlustleistungen in den Schaltschränken auftreten, da eine Wärmeabfuhr über die Schaltschrankoberflache allein oft nicht ausreichend ist.

Zwar wäre zur Erhaltung der Schutzart der Einsatz von Wärmetauschern möglich, dies ist aus Platzgründen und aus Kostengründen im Allgemeinen aber nicht umsetzbar. Alternativ ist der Einsatz von Standard-Filterlüftern möglich, welche die erforderlichen Schutzarten aber nur dann erreichen, wenn der Schaltschrank eine definierte Position hat, sodass kein Wasser durch Lamellen oder Kiemen des Filterlüfters eindringen kann. Diese definierte Position ist bei Pitch-Schaltschänken aber nicht gegeben, da sie im Rotor oder in der Rotornabe der Windkraftanlage angeordnet sind und wegen der Drehung des Rotors einem ständigen Lagewechsel unterliegen. Die an der Außenseite von handelsüblichen Filterlüftern angeordneten Lamellen weisen in normaler Einbaulage nach unten, sodass die Lufteintrittsöffnung des Lüfters gegen Strahlwasser von oben abgedeckt ist. Bei der Anwendung im Rotor einer Windkraftanlage durchläuft der Filterlüfter jedoch auch Positionen, bei denen die Lamellen nach oben zeigen und somit einen Wassereintritt leicht ermöglichen. Dabei ist in der Rotomabe mit Wasser in nicht unerheblicher Menge zu rechnen (z.B. Kondenswasser aus den Rotorblättern).

Ausgehend von diesem Stand der Technik liegt der Erfindung die Aufgabe zugrunde, einen Schaltschrank der eingangs genannten Art derart weiterzubilden, dass ein Eindringen von Wasser in den Lüfter auch bei einem ständigen Lagewechsel verhindert werden kann.

Diese Aufgabe wird erfingdungsgemäß durch einen Schaltschrank nach Anspruch 1 gelöst. Bevorzugte Weiterbildungen sind in den Unteransprüchen gegeben.

Der erfindungsgemäße Schaltschrank für eine Windkraftanlage, der im Betrieb, d.h. insbesondere im Betrieb der Windkraftanlage, einer Rotation ausgesetzt ist, weist ein Schrankgehäuse, in dem wenigstens ein Lüftungsloch in einer Wand des Schrankgehäuses vorgesehen ist, und wenigstens einen in dem Schrankgehäuse angeordneten Lüfter auf, der vor und/oder in dem Lüftungsloch sitzend an dem Schrankgehäuse befestigt ist. Dabei ist die Öffnung des Lüftungslochs an der Außenseite des Schrankgehäuses von einem umlaufenden und an der Außenseite der Gehäusewand befestigten Süllrand umgeben, der in einen Innenraum einer topfförmigen Abdeckung eingreift, die eine geschlossene Stirnseite und eine umlaufende Berandung aufweist, die den Süllrand teilweise übergreift, wobei die Abdeckung an dem Süllrand befestigt ist und einen Abstand zu diesem aufweist, sodass ein Luftleitkanal geschaffen wird, der eine luftdurchlässige Verbindung zwischen dem Lüfter bzw. dem Lüftungsloch und der Umgebung des Schrankgehäuses ausbildet. Der Süllrand greift somit in den Innenraum der an der Außenseite des Schrankgehäuses vorgesehenen Abdeckung unter Ausbildung einer luftdurchlässigen Verbindung zwischen dem Lüfter und der Umgebung des Schrankgehäuses ein.

Der von dem Süllrand umgebene oder umschlossene Raum und somit auch der Lüfter sind von der geschlossenen Stirnseite der Abdeckung gegen ein frontales Eindringen von Wasser geschützt. Ferner wird durch das Eingreifen des Süllrands in den Innenraum der Abdeckung ein labyrinthartiger Verlauf der luftdurchlässigen Verbindung geschaffen, sodass auch ein seitliches Eindringen von Wasser in den von dem Süllrand umgebenen Raum und somit in den Lüfter verhindert werden kann. Dabei ist trotz der Abdeckung ein Luftaustausch zwischen dem Inneren des Gehäuses und der Umgebung wegen der luftdurchlässigen Verbindung möglich.

Die luftdurchlässigen Verbindung verläuft bevorzugt zumindest abschnittsweise zwischen dem Süllrand und der Abdeckung, die dafür insbesondere einen Abstand zu der Umfangsfläche bzw. zu der umlaufenden Außenfläche des Süllrands aufweist. Ferner verläuft die luftdurchlässige Verbindung bevorzugt um den stirnseitigen Rand des Süllrands herum in den von dem Süllrand umgebenen oder umschlossenen Raum hinein, sodass der stirnseitige Rand des Süllrands insbesondere einen Abstand zu der geschlossenen Stirnseite der Abdeckung aufweist.

Die umlaufende Berandung der Abdeckung ist bevorzugt eine den Süllrand umlaufende Berandung, die insbesondere einen Abstand zu dem Süllrand aufweist, sodass die luftdurchlässige Verbindung zumindest teilweise zwischen der Berandung und dem Süllrand verläuft. Dabei ist der zwischen der Berandung und dem Süllrand eingeschlossene Raum bevorzugt ein umlaufender Freiraum, der insbesondere einen Abschnitt der luftdurchlässigen Verbindung bildet. Somit steht eine relativ große Luftdurchtrittsfläche für den Austausch von Luft zwischen dem Inneren des Gehäuses und der Umgebung zur Verfügung.

Die Umfangsfläche bzw. die umlaufende Außenfläche des Süllrands ist bevorzugt mit einer umlaufenden Vertiefung versehen, sodass seitlich eindringendes Wasser nicht um den stirnseitigen Rand des Süllrands herumlaufen und in den von dem Süllrand umgebenen oder umschlossenen Raum eindringen kann. Die Vertiefung ist insbesondere U-förmig, V-förmig oder konkav ausgebildet.

Der Süllrand kann eine runde, ovale oder eckige Umfangskontur aufweisen. Ferner weist die Abdeckung bevorzugt eine der Umfangskontur des Süllrands folgende Umfangskontur auf, sodass auch die Abdeckung eine runde, ovale oder eckige Umfangskontur aufweisen kann. Die Abdeckung ist insbesondere im Querschnitt U-förmig. Ferner weist die Abdeckung eine dem Schrankgehäuse zugewandte Öffnung auf, durch welche hindurch der Süllrand in den Innenraum der Abdeckung eingreift, wobei die oder alle Außenflächen der Abdeckung bevorzugt flüssigkeitsdicht oder spritzwasserdicht ausgebildet sind.

Der Süllrand kann mit dem Schrankgehäuse einstückig ausgebildet sein. Bevorzugt ist der an der Außenseite des Schrankgehäuses befestigte Süllrand aber ein separates Bauteil. Ferner ist die Verbindung zwischen dem Süllrand und dem Schrankgehäuse insbesondere flüssigkeitsdicht oder spritzwasserdicht ausgebildet, sodass ein Eindringen von Flüssigkeit in einen Spalt zwischen dem Süllrand und dem Schrankgehäuse verhindert werden kann. Bevorzugt können Abstandshalter zwischen dem Süllrand und der Abdeckung vorgesehen sein.

Der in dem Schrankgehäuse angeordnete Lüfter kann vor dem Lüftungsloch sitzen und/oder in das Lüftungsloch eingreifen. Ferner ist es möglich, dass der Lüfter das Lüftungsloch durchgreift und an der Außenseite des Schrank gehäuses hervorsteht, sodass der Lüfter in den von dem Süllrand umgebenen oder umschlossenen Raum eingreift und somit von dem Süllrand umgeben ist.

Der Lüfter weist bevorzugt Lamellen auf. Ferner umfasst der Lüfter bevorzugt einen Filter oder Staubfilter, der insbesondere von den Lamellen abgedeckt ist. Somit können handelsübliche Filterlüfter verwendet werden, die vergleichsweise kostengünstig erhältlich sind.

Die Abdeckung und der Süllrand können aus Metall und/oder Kunststoff bestehen. Ferner kann das Schrankgehäuse aus Metall und/oder Kunststoff gebildet sein. Bevorzugt ist das Schrankgehäuse als geschlossenes Gehäuse ausgebildet, das insbesondere mit einem abnehmbaren Deckel oder einer öffbaren Klappe oder Tür versehen ist, um einen verschließbaren Zugang zum Innenraum des Gehäuses zu schaffen.

Die Erfindung betrifft ferner eine Windkraftanklage mit einer Halterung, einem an der Halterung drehbar gelagerten Rotor, der wenigstens zwei Rotorblätter umfasst und mit einem elektrischen Generator gekoppelt ist, wobei wenigstens ein Schaltschrank in oder an dem Rotor, bevorzugt in dessen Rotornabe, befestigt ist. Bei dem Schaltschrank handelt es sich insbesondere um einen erfindungsgemäßen Schaltschrank, der gemäß allen genannten Ausgestaltungen weitergebildet sein kann.

Die Erfindung wird nachfolgend anhand einer bevorzugten Ausführungsform unter Bezugnahme auf die Zeichnung beschrieben. In der Zeichnung zeigen:
- Fig. 1: eine schematische Darstellung einer Windkraftanlage mit einem Schaltschrank gemäß einer Ausführungsform der Erfindung,
- Fig. 2: eine teilweise Schnittansicht des Schaltschranks nach Fig. 1,
- Fig. 3: eine Außenansicht des Schaltschranks bei abgenommener Abdeckung und
- Fig. 4: die Außenansicht nach Fig. 3 mit aufgesetzter Abdeckung.

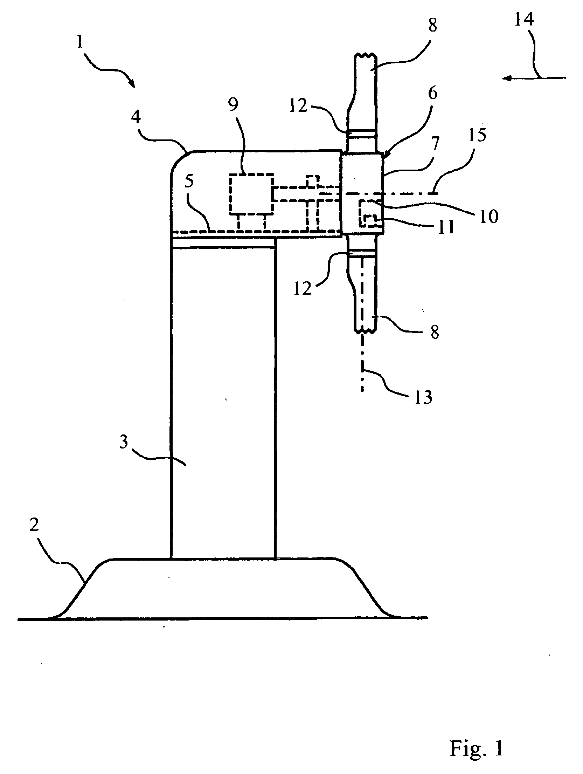

Aus Fig. 1 ist eine schematische Ansicht einer Windkraftanlage 1 ersichtlich, die einen auf einem Fundament 2 aufstehenden Turm 3 aufweist, an dessen dem Fundament 2 abgewandten Ende ein Maschinenhaus 4 angeordnet ist. Das Maschinenhaus 4 weist eine Halterung (Träger) 5 auf, an der ein Rotor 6 drehbar gelagert ist, der eine Rotornabe 7 und mit dieser verbundene Rotorblätter 8 umfasst. Der Rotor 6 ist mechanisch mit einem elektrischen Generator 9 gekoppelt, der in dem Maschinenhaus 4 angeordnet und an dem Träger 5 befestigt ist.

In der Rotornabe 7 ist ein Schaltschrank 10 angeordnet und befestigt, der elektronische Komponenten 11 umfasst, die insbesondere zur Ansteuerung von Pitch-Antrieben 12 dienen, mittels welchen die Rotorblätter 8 um ihre jeweilige Längsachse 13 relativ zur Rotornabe 7 gedreht werden können. Da der Rotor 6 durch Windkraft 14 um eine Rotorachse 15 gedreht wird, dreht sich auch der Schaltschrank 10 zusammen mit der Rotornabe 7.

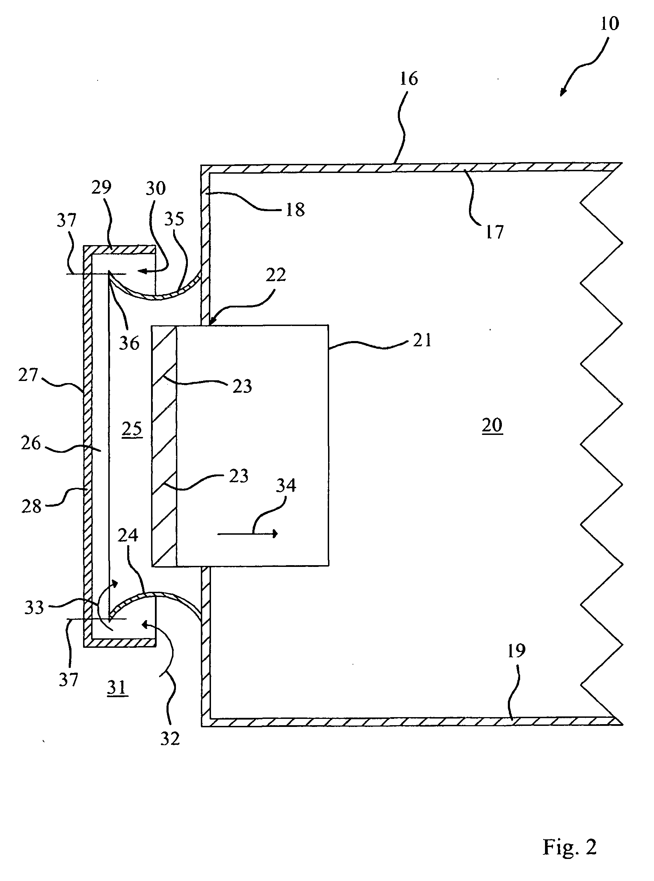

Aus Fig. 2 ist eine teilweise Schnittansicht des Schaltschranks 10 ersichtlich, der ein Schrankgehäuse 16 mit mehreren Wänden 17, 18 und 19 aufweist. Im Innenraum 20 des Schrankgehäuses 16 ist ein Filterlüfter 21 angeordnet und befestigt, der sich durch ein durchgehendes Lüftungsloch 22 hindurch erstreckt, welches in der Wand 18 vorgesehen ist. Der Lüfter 21 ist stimseitig mit Lamellen 23 versehen, die in der gezeigten Position des Schaltschranks 10 ausgehend von dem Lüfter 21 schräg nach unten verlaufen. An der Außenseite des Gehäuses 16 ist die Öffnung des Lüftungslochs 22 von einem umlaufenden Süllrand 24 umgeben bzw. umringt, der an der Außenseite der Gehäusewand 18 befestigt ist. Dabei sitzt ein Teil des Lüfters 21 zusammen mit den Lamellen 23 in dem von dem Süllrand 24 umgebenen bzw. umschlossenen Raum 25. Der Süllrand 24 greift in den Innenraum 26 einer topfförmigen Abdeckung 27 ein, die eine geschlossene Stirnseite 28 und eine umlaufende Berandung 29 aufweist, die den Süllrand 24 teilweise übergreift. Die Abdeckung 27 ist an dem Süllrand 24 mittels lediglich schematisch dargestellter Schraubverbindungen 37 befestigt und weist einen Abstand zu diesem auf, sodass ein Luftleitkanal 30 geschaffen wird, der eine luftdurchlässige Verbindung zwischen dem Lüfter 21 bzw. dem Lüftungsloch 22 und der Umgebung 31 des Schrankgehäuses 16 ausbildet. Somit kann der Lüfter 21 Luft aus der Umgebung 31 ansaugen und in den Innenraum 20 des Gehäuses 16 transportieren. Die Luft strömt dazu z.B. in Richtung des Pfeils 32 in den Luftleitkanal 30 ein, dann in Richtung des Pfeils 33 um den stirnseitigen Rand 36 des Süllrands 24 herum in den Innenraum 25 und von dort in Richtung des Pfeils 34 durch den Lüfter 21 hindurch in den Innenraum 20 des Gehäuses 16. Selbstverständlich ist es möglich, bei umgekehrten Betrieb des Lüfters 21 Luft aus dem Innenraum 20 in die Umgebung 31 abzuführen, wobei die Luft in Gegenrichtung der Pfeile 34, 33 und 32 strömt.

Die umlaufende Außenfläche 35 des Süllrands 24 ist konkav ausgebildet, sodass seitlich eindringendes Wasser nicht über den stirnseitigen Rand 36 des Süllrands 24 herum in den Innenraum 25 eintreten kann.

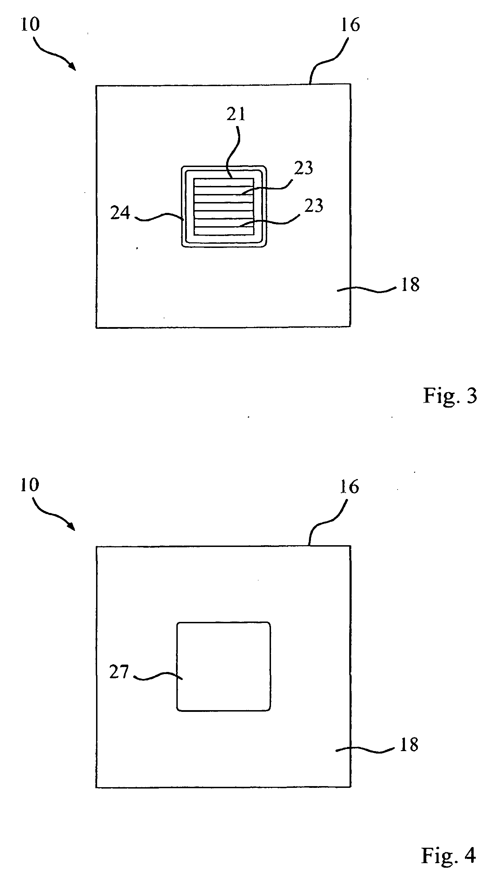

Fig. 3 zeigt eine Außenansicht des Schaltschranks 10 bei abgenommener Abdeckung 27, wobei ersichtlich ist, dass der Süllrand 24 eine im Wesentlichen viereckige Umfangskontur aufweist. Ferner zeigt Fig. 4 die Außenansicht nach Fig. 3 mit aufgesetzter Abdeckung 27, sodass ersichtlich ist, dass auch die Abdeckung 27 eine im Wesentlichen viereckige Umfangskontur aufweist.

### Bezugszeichenliste

- 1: Windkraftanlage
- 2: Fundament
- 3: Turm
- 4: Maschinenhaus
- 5: Träger / Halterung
- 6: Rotor
- 7: Rotomabe
- 8: Rotorblatt
- 9: elektrischer Generator
- 10: Schaltschrank
- 11: elektronische Komponenten
- 12: Pitch-Antrieb
- 13: Längsachse des Rotorblatts
- 14: Wind
- 15: Rotorachse
- 16: Schrankgehäuse
- 17: Gehäusewand
- 18: Gehäusewand
- 19: Gehäusewand
- 20: Gehäuseinnenraum
- 21: Filterlüfter
- 22: Lüftungsloch
- 23: Lamelle
- 24: Süllrand
- 25: Raum, von Süllrand umgeben
- 26: Innenraum der Abdeckung
- 27: Abdeckung
- 28: Stirnseite der Abdeckung
- 29: Berandung der Abdeckung
- 30: Luftleitkanal
- 31: Umgebung
- 32: Luftströmung
- 33: Luftströmung
- 34: Luftströmung
- 35: Außenfläche des Süllrands
- 36: stirnseitiger Rand des Süllrands
- 37: Schraubverbindung

## Patentansprüche

1. Schaltschrank für eine Windkraftanlage, der im Betrieb einer Rotation ausgesetzt ist, mit einem Schrankgehäuse (16), in dem wenigstens ein Lüftungsloch (22) in einer Wand des Schrankgehäuses vorgesehen ist, wenigstens einem in dem Schrankgehäuse (16) angeordneten Lüfter (21), der vor und/oder in dem Lüftungsloch (22) sitzend an dem Schrankgehäuse (16) befestigt ist, **dadurch gekennzeichnet, dass** an der Außenseite des Schrankgehäuses (16) die Öffnung des Lüftungslochs (22) von einem umlaufenden und an der Außenseite der Gehäusewand (18) befestigten Süllrand (24) umgeben ist, der in den Innenraum (26) einer topfförmigen Abdeckung (27) eingreift, die eine geschlossene Stirnseite (28) und eine umlaufende Bcrandung (29) aufweist, die den Süllrand teilweise übergreift, wobei die Abdeckung (27) an dem Süllrand (24) befestigt ist und einen Abstand zu diesem aufweist, sodass ein Luftleitkanal (30) geschaffen wird, der eine luftdurchlässige Verbindung zwischen dem Lüfter (21) bzw. dem Lüftungsloch (22) und der Umgebung (31) des Schrankgehäuses (16) ausbildet.

2. Schaltschrank nach Anspruch 1, **dadurch gekennzeichnet, dass** die Umfangskontur der Abdeckung (27) der Umfangskontur des Sülltands (24) folgt.

3. Schaltschrank nach Anspruch 1 oder 2, **dadurch gekennzeichnet, dass** die Umfangfläche (35) des Süllrands (24) mit einer umlaufenden Vertiefung versehen ist.

4. Schaltschrank nach einem der vorangehenden Ansprüche, **dadurch gekennzeichnet, dass** die Abdeckung (27) im Querschnitt U-förmig ist.

5. Schaltschrank nach einem der vorangehenden Ansprüche **dadurch gekennzeichnet, dass** der Süllrand (24) und die Abdeckung (27) eine eckige Umfangskontur aufweisen.

6. Schaltschrank nach einem der vorangehenden Ansprüche, **dadurch gekennzeichnet, dass** der Lüfter (21) sich durch das Lüftungsloch (22) hindurch erstreckt.

7. Schaltschrank nach einem der vorangehenden Ansprüche, **dadurch gekennzeichnet, dass** der Lüfter Lamellen (23) aufweist.

8. Schaltschrank nach einem der vorangehenden Ansprüche, **dadurch gekennzeichnet, dass** das Lüftungsloch (22) in einer Wand (18) des Schrankgehäuses (16) vorgesehen ist, zu der die umlaufende Berandung (29) einen Abstand aufweist.

9. Schaltschrank nach Anspruch 8, **dadurch gekennzeichnet, dass** die Abdeckung (27) an ihrer der Wand (18) abgewandten Seite eine geschlossene Stirnseite (28) aufweist, von der aus sich die umlaufende Berandung (29) in Richtung der Wand (18) erstreckt und mit dem Süllrand (24) überlappt.

10. Windkraftanlage mit einer Halterung (5) und einem an der Halterung (5) drehbar gelagerten Rotor (6), der wenigstens zwei Rotorblätter (8) aufweist und mit einem elektrischen Generator (9) gekoppelt ist, **dadurch gekennzeichnet, dass** wenigstens ein SchaltschranK (10) nach einem der vorangehenden Ansprüche in oder an dem Rotor (6) befestigt ist.

11. Windkraftanlage nach Anspruch 10, **dadurch gekennzeichnet, dass** der Schaltschrank (11) in einer Rotomabe (7) des Rotor (6) befestigt ist und im Betrieb dadurch einer Rotation ausgesetzt ist, dass der Rotor (6) durch Windkraft (14) um eine Rotorachse (15) gedreht wird, sodass sich auch der Schaltschrank (10) zusammen mit der Rotornabe (7) dreht.

## Claims

1. Switch cabinet for a wind turbine which is subject to rotation during operation with a cabinet housing (16) in which at least one ventilation hole (22) is provided in a wall of the cabinet housing, at least one fan (21) arranged in the cabinet housing (16) which is fastened seated at the cabinet housing (16) in front of and/or in the ventilation hole (22),
**characterized in that** at the outside of the cabinet housing (16) the opening of the ventilation hole (22) is surrounded by a circumferential coaming (24) fastened on the outside of the housing wall (18), which engages in the interior (26) of a pot-shaped cover (27) which has a closed face side (28) and a circumferential boundary (29) which partially overlaps the coaming, whereby the cover (27) is fastened at the coaming (24) and is distanced from it in such a way that an air guidance channel (30) is created which forms an air permeable connection between the fan (21) / the ventilation hole (22) and the surrounding area (31) around the cabinet housing (16).

2. Switch cabinet in accordance with claim 1, **characterized in that** the perimeter of the cover (27) follows the perimeter of the coaming (24).

3. Switch cabinet in accordance with claim 1 or 2, **characterized in that** the circumferential surface (35) of the coaming (24) has a peripheral recess.

4. Switch cabinet in accordance with one of the previous claims, **characterized in that** the cover (27) has a U-shaped cross-section.

5. Switch cabinet in accordance with one of the previous claims, **characterized in that** the coaming (24) and the cover (27) have an angular perimeter.

6. Switch cabinet in accordance with one of the previous claims, **characterized in that** the fan (21) projects through the ventilation hole (22).

7. Switch cabinet in accordance with one of the previous claims, **characterized in that** the fan has impeller blades (23).

8. Switch cabinet in accordance with one of the previous claims, **characterized in that** the ventilation hole (22) is provided in a wall (18) of the cabinet housing (16) which is located at a distance from the circumferential boundary (29).

9. Switch cabinet in accordance with claim 8, **characterized in that** the cover (27) has a closed face side (28) at the side facing away from the wall (18), from which the circumferential boundary (29) stretches in the direction of the wall (18) and overlaps with the coaming (24).

10. Wind turbine with a fixture (5) and a rotor (6) mounted in rotary bearings at the fixture (5) which has at least two rotor blades (8) and is coupled to an electrical generator (9), **characterized in that** at least one switch cabinet (10) in accordance with one of the previous claims is fastened in or at the rotor (6).

11. Wind turbine in accordance with claim 10, **characterized in that** the switch cabinet (11) is fastened in a rotor hub (7) of the rotor (6) and is subject to rotation during operation such that the rotor (6) is rotated by wind power (14) around a rotor axis (15), causing the switch cabinet (10) to rotate together with the rotor hub (7).

## Revendications

1. Armoire électrique pour une éolienne qui, en service, est exposée à une rotation, avec un boîtier d'armoire (16), dans laquelle il est prévu au moins un trou d'aération (22) dans une paroi du boîtier d'armoire, au moins un ventilateur (21) placé dans le boîtier d'armoire (16), qui est fixé devant et/ou dans le trou d'aération (22), plaquant contre le boîtier d'armoire (16), **caractérisée en ce que**, du côté extérieur du boîtier d'armoire (16), l'ouverture du trou d'aération (22) est entourée par un surbau (24) périphérique et fixé du côté extérieur de la paroi du boîtier (18), qui engrène dans la zone intérieure (26) d'un capot en forme de pot (27), qui présente une face frontale fermée (28) et une bordure périphérique (29) qui empiète en partie sur le surbau, le capot (27) étant fixé sur le surbau (24) et présentant par rapport à celui-ci un écartement créant un canal conducteur d'air (30) qui constitue une liaison perméable à l'air entre le ventilateur (21) ou le trou d'aération (22) et l'environnement (31) du boîtier d'armoire (16).

2. Armoire électrique selon revendication 1, **caractérisée en ce que** le contour périphérique du capot (27) suit le contour périphérique du surbau (24).

3. Armoire électrique selon revendication 1 ou 2, **caractérisée en ce que** la surface périphérique (35) du surbau (24) est munie d'un creux périphérique.

4. Armoire électrique selon l'une des revendications précédentes, **caractérisée en ce que** le capot (27) présente une section en U.

5. Armoire électrique selon l'une des revendications précédentes, **caractérisée en ce que** le surbau (24) et le capot (27) présentent un contour périphérique rectangulaire.

6. Armoire électrique selon l'une des revendications précédentes, **caractérisée en ce que** le ventilateur (21) traverse le trou d'aération (22).

7. Armoire électrique selon l'une des revendications précédentes, **caractérisée en ce que** le ventilateur présente des lamelles (23).

8. Armoire électrique selon l'une des revendications précédentes, **caractérisée en ce que** le trou d'aération (22) est prévu dans une paroi (18) du boîtier d'armoire (16), par rapport à laquelle la bordure périphérique (29) présente un écartement.

9. Armoire électrique selon revendication 8, **caractérisée en ce que** le capot (27) présente, sur son côté opposé à la paroi (18), une face frontale fermée (28) à partir de laquelle la bordure périphérique (29) s'étend en direction de la paroi (18) et se chevauche avec le surbau (24).

10. Eolienne avec un support (5) et un rotor (6) monté rotatif sur le support (5), qui présente au moins deux pales de rotor (8) et est accouplé à un générateur électrique (9), **caractérisée en ce que** une armoire électrique (10) au moins est fixée dans ou sur le rotor (6), selon l'une des revendications précédentes.

11. Eolienne selon revendication 10, **caractérisée en ce que** l'armoire électrique (11) est fixée dans un moyeu (7) du rotor (6) et est exposée en service à une rotation par le fait que le rotor (6) tourne, sous l'effet de la force du vent (14), autour d'un axe de rotor (15), ce qui fait que l'armoire électrique (10) tourne également conjointement avec le moyeu de rotor (7).
